# EUROPEAN PATENT APPLICATION

(11) **EP 2 701 480 A2**
(43) Date of publication of application: **26.02.2014**
(21) Application number: 13173397.4
(22) Date of filing: 24.06.2013
(51) Int. Cl.: H05K 9/00

(54) **Package structure and electronic apparatus**

(30) Priority: 24.08.2012 JP 2012185877
(71) Applicant: FUJITSU LIMITED, Kawasaki-shi, Kanagawa 211-8588 (JP)
(72) Inventor: Sawada, Katsuki, Kawasaki-shi, Kanagawa 211-8588 (JP)
(74) Representative: Schultes, Stephan

(57) **Abstract**

A package structure includes: a plurality of substrates that have components mounted thereon; and a shielding member that is provided between the plurality of substrates and that collectively shields the components of the plurality of substrates, wherein the plurality of substrates are disposed parallel to each other such that surfaces thereof having the components mounted thereon face each other.

## Description

### FIELD

The embodiments discussed herein are related to package structures that shield electronic circuit substrates within electronic apparatuses.

### BACKGROUND

In the related art, relatively compact electronic apparatuses, such as mobile phones, game devices, and wearable terminal devices, have small housings in which electronic circuits are packaged with high density. Electronic circuits mounted on electronic circuit substrates include a mixture of a circuit that generates an electromagnetic wave and an electronic circuit that tends to malfunction owing to the effect of an electromagnetic wave generated from another electronic circuit. Therefore, shielding plates composed of, for example, metal are used to cover the electronic circuit that generates an electromagnetic wave and the electronic circuit that tends to malfunction owing to the effect of an electromagnetic wave generated from another electronic circuit.

Generally, in such an electronic apparatus, a technique of stacking electronic circuit substrates is employed so as to allow for high-density packaging. However, stacking a plurality of electronic circuit substrates that have individual shielding plates may adversely affect high-density packaging since, for example, it may be difficult to fit the electronic circuit substrates within the electronic apparatus.

The following is reference documents:
[Document 1] Japanese Laid-open Patent Publication No. 2004-260103 and
[Document 2] Japanese Laid-open Patent Publication No. 08-213500.

### SUMMARY

According to an aspect of the invention, a package structure includes: a plurality of substrates that have components mounted thereon; and a shielding member that is provided between the plurality of substrates and that collectively shields the components of the plurality of substrates, wherein the plurality of substrates are disposed parallel to each other such that surfaces thereof having the components mounted thereon face each other.

The object and advantages of the invention will be realized and attained by means of the elements and combinations particularly pointed out in the claims. It is to be understood that both the foregoing general description and the following detailed description are exemplary and explanatory and are not restrictive of the invention, as claimed.

### BRIEF DESCRIPTION OF DRAWINGS

FIGs. 1A and 1B illustrate a problem in a comparative example;
FIGs. 2A and 2B illustrate a package structure according to a first embodiment;
FIGs. 3A and 3B illustrate a package structure according to a second embodiment;
FIGs. 4A and 4B illustrate a package structure according to a third embodiment;
FIGs. 5A and 5B illustrate a package structure according to a fourth embodiment;
FIGs. 6A and 6B illustrate a package structure according to a fifth embodiment;
FIGs. 7A to 7D illustrate a method for manufacturing the package structure according to the first embodiment;
FIGs. 8A to 8D illustrate connection techniques between a shielding plate and an electronic circuit substrate;
FIGs. 9A and 9B illustrate a sixth embodiment in which two or more electronic circuit substrates are collectively shielded; and
FIGs. 10A and 10B illustrate a package structure according to a seventh embodiment.

### DESCRIPTION OF EMBODIMENTS

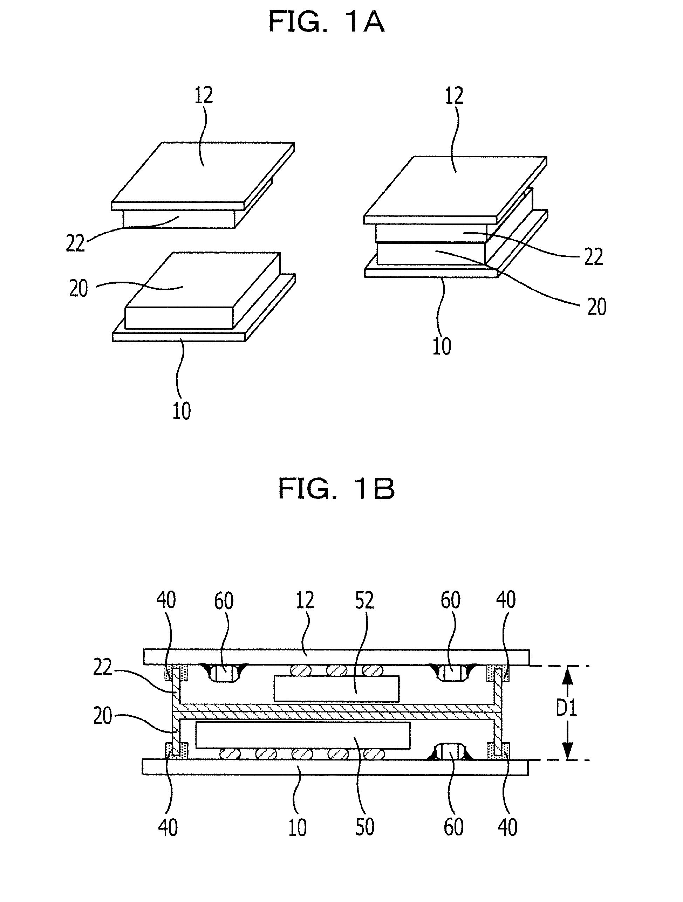

First, the following description with reference to FIGs. 1A and 1B is related to a problem existing in a comparative example in which a plurality of electronic circuit substrates individually having shielding plates are stacked.

FIG. 1A illustrates how two electronic circuit substrates individually having shielding plates are stacked.

A shielding plate 20 that shields an electronic circuit is mounted on a first electronic circuit substrate 10. A shielding plate 22 that shields an electronic circuit is mounted on a second electronic circuit substrate 12. These two electronic circuit substrates 10 and 12 are installed within an electronic apparatus such that the surfaces with the electronic circuits, that is, the surfaces having the shielding plates 20 and 22 mounted thereon, face each other.

FIG. 1B is a cross-sectional view for explaining the structure of the two stacked electronic circuit substrates 10 and 12.

A semiconductor device 50 and passive components 60, such as a capacitor and a coil, are mounted on the first electronic circuit substrate 10. A plurality of on-board clips 40 that secure the shielding plate 20 are mounted on the first electronic circuit substrate 10 in an area surrounding the semiconductor device 50 and the passive components 60. By using the on-board clips 40, the shielding plate 20 is secured in position.

Likewise, a semiconductor device 52 and passive components 60, such as a capacitor and a coil, are mounted on the second electronic circuit substrate 12. A plurality of on-board clips 40 that secure the shielding plate 22 are mounted on the second electronic circuit substrate 12 in an area surrounding the semiconductor device 52 and the passive components 60. By using the on-board clips 40, the shielding plate 22 is secured in position.

In the case where the shielding-plate-mounted surface of the first electronic circuit substrate 10 and the shielding-plate-mounted surface of the second electronic circuit substrate 12 face each other, the two shielding plates 20 and 22 abut against each other, thus making it difficult to further reduce a distance D1 between the first electronic circuit substrate 10 and the second electronic circuit substrate 12. This is a hindrance to achieving higher packaging density within the electronic apparatus.

Detailed descriptions of embodiments will be provided below with reference to the drawings.

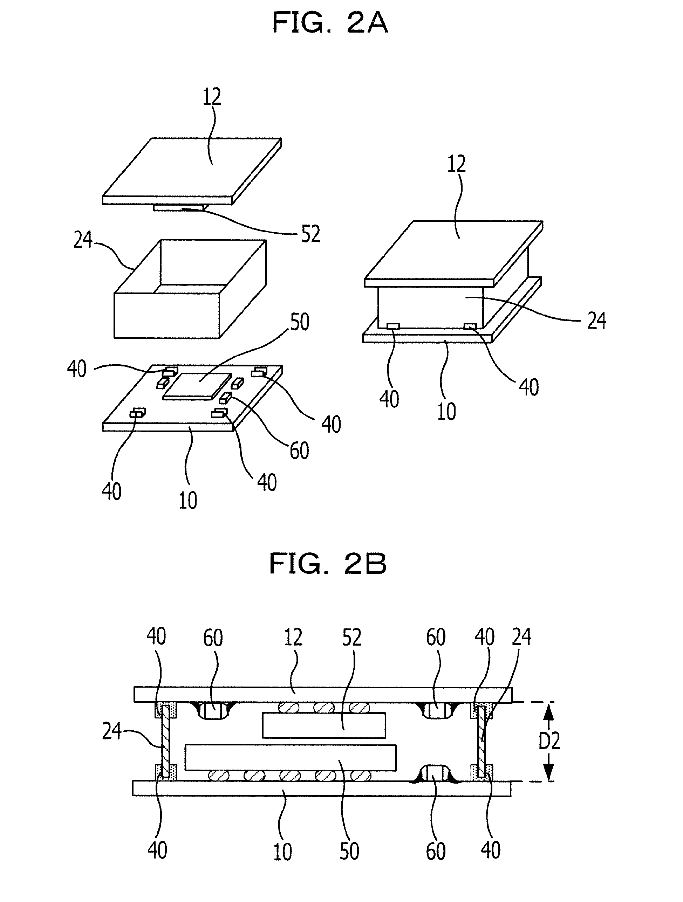

FIGs. 2A and 2B illustrate a package structure according to a first embodiment. FIG. 2A illustrates how two electronic circuit substrates 10 and 12 are shielded by a single shielding plate 24. FIG. 2B is a cross-sectional view of a structure in which the two electronic circuit substrates 10 and 12 are shielded by the single shielding plate 24. In the first embodiment, the shielding plate 24 is a rectangular-frame-shaped plate composed of, for example, metal.

Electronic components, including a semiconductor device 50 and passive components 60, such as a capacitor and a coil, are mounted on the first electronic circuit substrate 10. These electronic components constitute an electronic circuit. The electronic circuit is a circuit that tends to generate an electromagnetic wave easily, such as a wireless transmitter-and-receiver circuit, an oscillation circuit that oscillates at high frequency, or a power supply circuit. Another example is a circuit that is susceptible to an electromagnetic wave from another electronic circuit, such as a storage unit.

A plurality of on-board clips 40 that secure the shielding plate 24 are mounted on the first electronic circuit substrate 10 in an area surrounding the semiconductor device 50 and the passive components 60. The on-board clips 40 are composed of an electrically conductive material, such as metal, so that the shielding plate 24 may be electrically connected to a ground layer within the first electronic circuit substrate 10.

Likewise, electronic components, including a semiconductor device 52 and passive components 60, such as a capacitor and a coil, are mounted on the second electronic circuit substrate 12. These electronic components constitute an electronic circuit. A plurality of on-board clips 40 that secure the shielding plate 24 are mounted on the second electronic circuit substrate 12 in an area surrounding the semiconductor device 52 and the passive components 60.

The first electronic circuit substrate 10 and the second electronic circuit substrate 12 sandwich the shielding plate 24 such that the electronic-component-mounted surfaces face each other.

Referring to FIG. 2B, the electronic components on the first electronic circuit substrate 10 and the electronic components on the second electronic circuit substrate 12 are surrounded by the first electronic circuit substrate 10, the second electronic circuit substrate 12, and the shielding plate 24. Although not depicted, each of the first electronic circuit substrate 10 and the second electronic circuit substrate 12 is a multilayer substrate including a ground layer therein. Because the shielding plate 24 is electrically connected to the ground layers via the on-board clips 40, the electronic components on the first electronic circuit substrate 10 and the electronic components on the second electronic circuit substrate 12 are completely shielded.

The electronic components on the first electronic circuit substrate 10 and the electronic components on the second electronic circuit substrate 12 are disposed in a back-to-back fashion and have no partition plates interposed therebetween. Thus, a distance D2 between the first electronic circuit substrate 10 and the second electronic circuit substrate 12 may be significantly reduced; as compared with the distance D1 between the first electronic circuit substrate 10 and the second electronic circuit substrate 12 in the comparative example. Therefore, the electronic apparatus may be reduced in size and thickness. Alternatively, since an extra space may be formed within the electronic apparatus, another electronic circuit may be added, thereby allowing for higher functionality of the electronic apparatus.

Furthermore, the two shielding plates 20 and 22 respectively provided for the first electronic circuit substrate 10 and the second electronic circuit substrate 12 in the comparative example are reduced to a single shielding plate 24, whereby the number of steps for manufacturing the shielding plate 24 may be significantly reduced. Since the shielding plate 24 according to the first embodiment has a simple rectangular frame shape, the manufacturing cost therefor may also be significantly reduced.

In the first embodiment, the electronic circuit of the first electronic circuit substrate 10 and the electronic circuit of the second electronic circuit substrate 12 are desirably electronic circuits that are not affected by each other's electromagnetic waves.

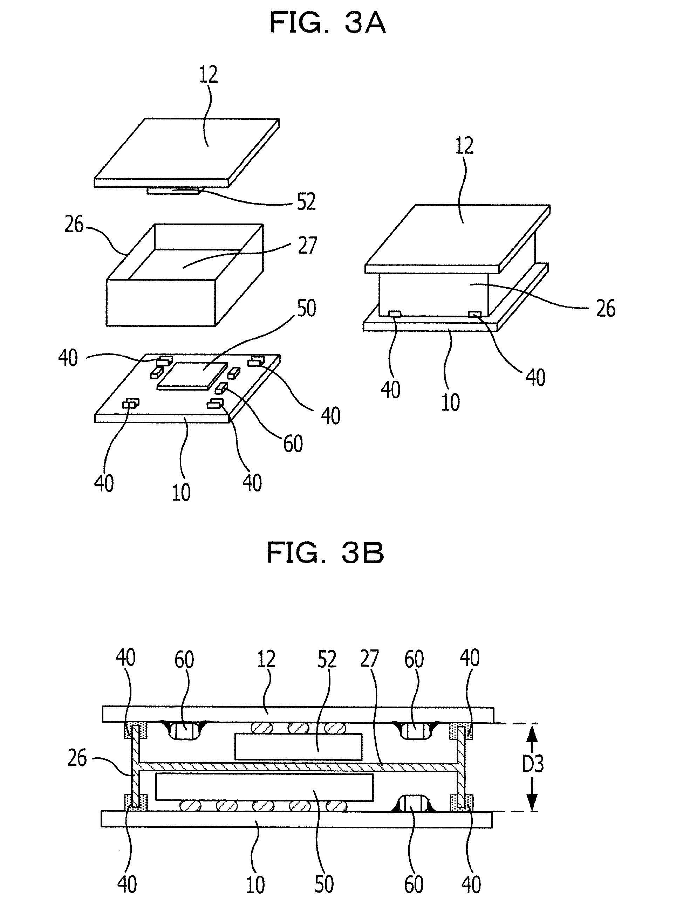

Next, a package structure according to a second embodiment will be described with reference to FIGs. 3A and 3B.

FIG. 3A illustrates how two electronic circuit substrates 10 and 12 are shielded by a single shielding plate 26. FIG. 3B is a cross-sectional view of a structure in which the two electronic circuit substrates 10 and 12 are shielded by the single shielding plate 26. In FIGs. 3A and 3B, elements that are the same as or equivalent to those in the package structure illustrated in FIGs. 2A and 2B are given the same reference numerals, and descriptions thereof will be omitted.

The shielding plate 26 according to the second embodiment is different from the shielding plate 24 according to the first embodiment in being provided with a partition plate 27 at an intermediate position. In the second embodiment, the electronic circuit of one of the electronic circuit substrates is less susceptible to an electromagnetic wave generated by the electronic circuit of the other electronic circuit substrate. In the second embodiment, although the single partition plate 27 is interposed between the electronic components on the first electronic circuit substrate 10 and the electronic components on the second electronic circuit substrate 12, a distance D3 between the first electronic circuit substrate 10 and the second electronic circuit substrate 12 may still be reduced, as compared with the distance D1 between the first electronic circuit substrate 10 and the second electronic circuit substrate 12 in the comparative example.

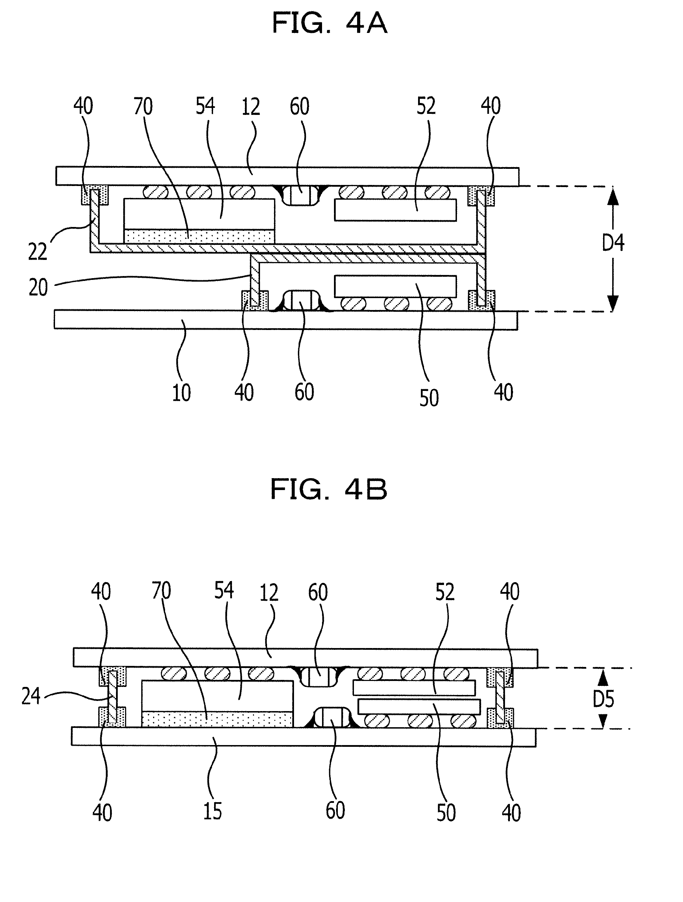

Next, a package structure according to a third embodiment will be described with reference to FIGs. 4A and 4B. FIG. 4A illustrates a package structure before the third embodiment is applied. FIG. 4B illustrates a package structure according to the third embodiment. In FIGs. 4A and 4B, elements that are the same as or equivalent to those in the package structure illustrated in FIGs. 2A and 2B are given the same reference numerals, and descriptions thereof will be omitted.

Referring to FIG. 4A, an electronic circuit constituted of a semiconductor device 50 and passive components 60, such as a capacitor and a coil, is formed on a first electronic circuit substrate 10, and the electronic circuit is shielded by a shielding plate 20. An electronic circuit constituted of a first semiconductor device 52, passive components 60, such as a capacitor and a coil, and a second semiconductor device 54 is formed on a second electronic circuit substrate 12, and the electronic circuit is shielded by a shielding plate 22. The second semiconductor device 54 generates a large amount of heat during operation thereof and has a larger height than the semiconductor device 52. The back surface of the second semiconductor device 54 is provided with a heat conducting member 70 that allows the heat generated by the second semiconductor device 54 to escape toward the shielding plate 22.

In the case where the first electronic circuit substrate 10 and the second electronic circuit substrate 12 are disposed such that the surfaces thereof with the electronic circuits, that is, the shielding-plate-mounted surfaces, face each other, as in FIG. 4A, the shielding plate 20 and the shielding plate 22 are in surface contact with each other. In this state, the heat generated by the second semiconductor device 54 is transmitted to the shielding plate 22 via the heat conducting member 70 and then further to the shielding plate 20. The heat transmitted to the shielding plate 20 is released from the first electronic circuit substrate 10 via on-board clips 40.

Referring to FIG. 4B, in accordance with the third embodiment, an electronic circuit on a first electronic circuit substrate 15 and the electronic circuit on the second electronic circuit substrate 12 are shielded by a single shielding plate 24. In the third embodiment, heat generated by the second semiconductor device 54 on the second electronic circuit substrate 12 is transmitted to the first electronic circuit substrate 15 via the heat conducting member 70 and is released from the first electronic circuit substrate 15. Since two shielding plates are not interposed between the two electronic circuit substrates 15 and 12, heat may be released with higher efficiency than in the case of FIG. 4A. Furthermore, a distance D5 between the first electronic circuit substrate 15 and the second electronic circuit substrate 12 may be significantly reduced, as compared with a distance D4 between the first electronic circuit substrate 10 and the second electronic circuit substrate 12 in the package structure before the third embodiment is applied.

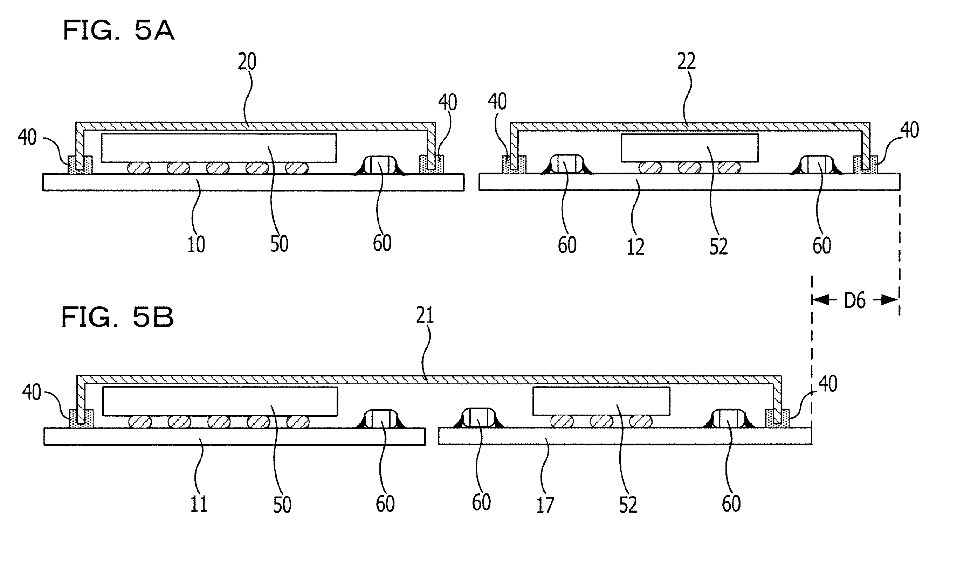

Next, a package structure according to a fourth embodiment will be described with reference to FIGs. 5A and 5B. FIG. 5A illustrates a package structure before the fourth embodiment is applied, in which a first electronic circuit substrate 10 and a second electronic circuit substrate 12 are disposed on the same plane. FIG. 5B illustrates a package structure according to the fourth embodiment. In FIGs. 5A and 5B, elements that are the same as or equivalent to those in the package structure illustrated in FIGs. 2A and 2B are given the same reference numerals, and descriptions thereof will be omitted.

Referring to FIG. 5A, the first electronic circuit substrate 10 and the second electronic circuit substrate 12 are disposed on the same plane. Referring to FIG. 5B, in accordance with the fourth embodiment, an electronic circuit on a first electronic circuit substrate 11 and an electronic circuit on a second electronic circuit substrate 17 are shielded by a single shielding plate 21. In the fourth embodiment, the on-board clip 40 of the first electronic circuit substrate 10 located in the middle of FIG. 5A and the on-board clip 40 of the second electronic circuit substrate 12 located in the middle of FIG. 5A are not provided, so that the mounting areas of the first electronic circuit substrate 11 and the second electronic circuit substrate 17 may be reduced. Thus, the total mounting space on the first electronic circuit substrate 11 and the second electronic circuit substrate 17 may be reduced by an amount equivalent to a distance D6.

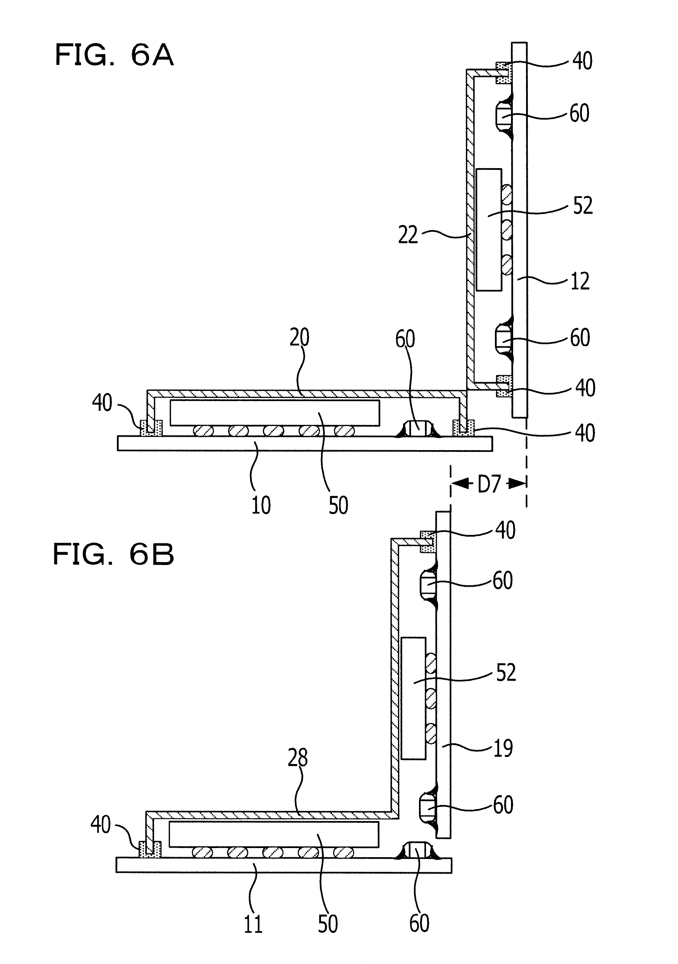

Next, a package structure according to a fifth embodiment will be described with reference to FIGs. 6A and 6B. FIG. 6A illustrates a package structure before the fifth embodiment is applied, in which a first electronic circuit substrate 10 and a second electronic circuit substrate 12 are disposed orthogonally to each other. FIG. 6B illustrates a package structure according to the fifth embodiment. In FIGs. 6A and 6B, elements that are the same as or equivalent to those in the package structure illustrated in FIGs. 2A and 2B are given the same reference numerals, and descriptions thereof will be omitted.

Referring to FIG. 6A, the first electronic circuit substrate 10 and the second electronic circuit substrate 12 are disposed orthogonally to each other. Reducing the distance between the two electronic circuit substrates 10 and 12 any further is difficult since the shielding plate 20 on the first electronic circuit substrate 10 and the shielding plate 22 on the second electronic circuit substrate 12 would come into contact with each other.

Referring to FIG. 6B, in accordance with the fifth embodiment, an electronic circuit on a first electronic circuit substrate 11 and an electronic circuit on a second electronic circuit substrate 19 are shielded by a single shielding plate 28. In the fifth embodiment, the first electronic circuit substrate 11 does not have an on-board clip 40 at the second electronic circuit substrate 19 side thereof, and the second electronic circuit substrate 19 does not have an on-board clip 40 at the first electronic circuit substrate 11 side thereof, so that the mounting areas of the first electronic circuit substrate 11 and the second electronic circuit substrate 19 may be reduced. Thus, the total mounting space on the first electronic circuit substrate 11 and the second electronic circuit substrate 19 may be reduced by an amount equivalent to a distance D7.

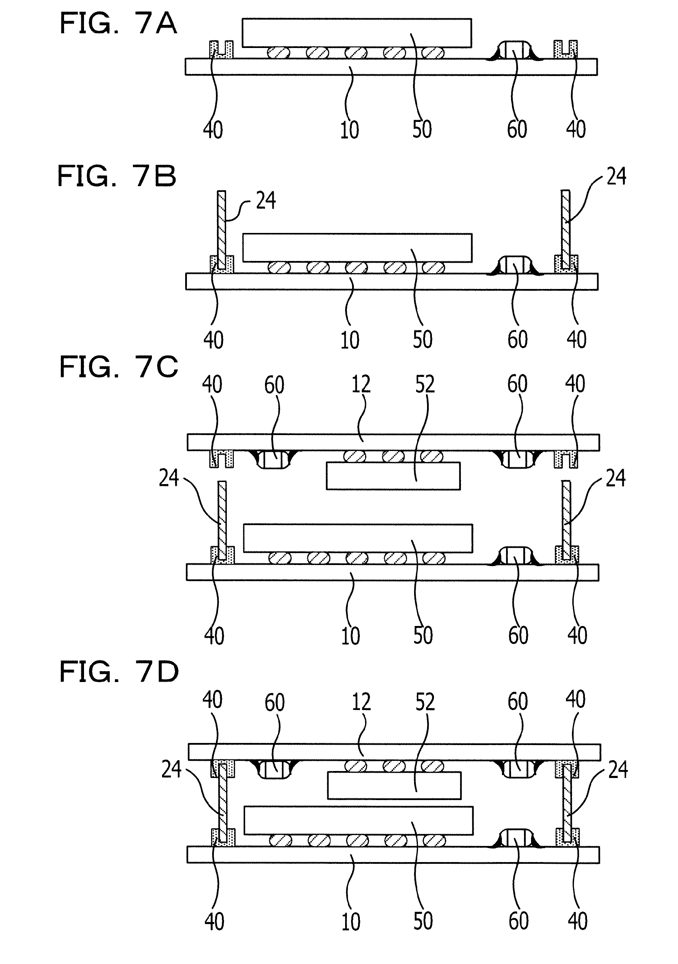

The following description with reference to FIGs. 7A to 7D is related to a manufacturing process of the package structure according to the first embodiment as an example.

First, referring to FIG. 7A, a first electronic circuit substrate 10 is prepared, and a semiconductor device 50 and passive components 60, such as a capacitor and a coil, are disposed on the first electronic circuit substrate 10. Then, a plurality of on-board clips 40 are disposed on the first electronic circuit substrate 10 in an area surrounding the semiconductor device 50 and the passive components 60. The on-board clips 40 are clip-shaped members mountable on the first electronic circuit substrate 10 and are disposed on pads (not depicted) on the first electronic circuit substrate 10 via an electrically conductive material, such as solder.

Likewise, a second electronic circuit substrate 12 (not depicted in FIG. 7A) is prepared, and a semiconductor device 52 and passive components 60, such as a capacitor and a coil, are disposed on the second electronic circuit substrate 12. Then, a plurality of on-board clips 40 are disposed on the second electronic circuit substrate 12 in an area surrounding the semiconductor device 52 and the passive components 60.

Then, referring to FIG. 7B, a shielding plate 24 is secured by being fitted into recesses formed in the middle of the on-board clips 40 on the first electronic circuit substrate 10.

Subsequently, referring to FIG. 7C, recesses formed in the middle of the on-board clips 40 on the second electronic circuit substrate 12 are positional aligned with the shielding plate 24 such that the electronic-component-mounted surface of the second electronic circuit substrate 12 faces the electronic components on the first electronic circuit substrate 10.

Then, referring to FIG. 7D, the recesses in the middle of the on-board clips 40 on the second electronic circuit substrate 12 are fitted to the shielding plate 24, thereby securing the second electronic circuit substrate 12 to the shielding plate 24.

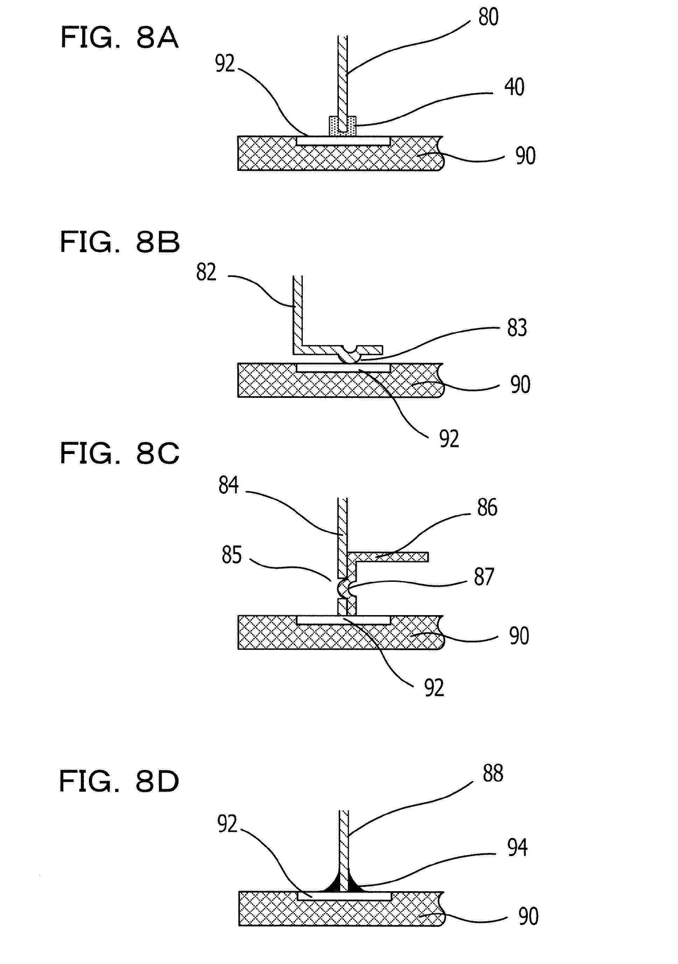

Next, connection techniques between a shielding plate and an electronic circuit substrate will be described with reference to FIGs. 8A to 8D. FIG. 8A illustrates a technique in which a shielding plate 80 is secured to an electronic circuit substrate 90 by using an on-board clip 40 described above. The on-board clip 40 is an electrically conductive clip-shaped member mountable on the electronic circuit substrate 90 and is fixed on an electrode pad 92 of the electronic circuit substrate 90 via an electrically conductive material, such as solder. The electrode pad 92 is electrically connected to a ground layer (not depicted) of the electronic circuit substrate 90. The shielding plate 80 is secured by fitting an end of the shielding plate 80 into a recess formed in the middle of the on-board clip 40.

FIG. 8B illustrates a technique in which a shielding plate 82 is brought into contact with the electronic circuit substrate 90. A protrusion 83 is formed at an end of the shielding plate 82. The protrusion 83 comes into contact with the electrode pad 92 of the electronic circuit substrate 90 so that the shielding plate 82 is electrically connected to the electronic circuit substrate 90.

FIG. 8C illustrates a technique in which a shielding plate 84 is secured to the electronic circuit substrate 90 by using a frame 86 in place of an on-board clip 40. The frame 86 that surrounds the electronic circuit is formed on the electronic circuit substrate 90. The frame 86 is secured to the electrode pad 92 via an electrically conductive material, such as solder. A protrusion 87 is formed in a side surface of the frame 86. An opening 85 is formed in an area, which corresponds to the protrusion 87, in a side surface of the shielding plate 84. The shielding plate 84 is secured to the frame 86 by fitting the protrusion 87 into the opening 85.

FIG. 8D illustrates a technique in which a shielding plate 88 is directly connected to the electronic circuit substrate 90 without using an on-board clip 40. The shielding plate 88 is secured to the electrode pad 92 by using an electrically conductive material 94, such as solder.

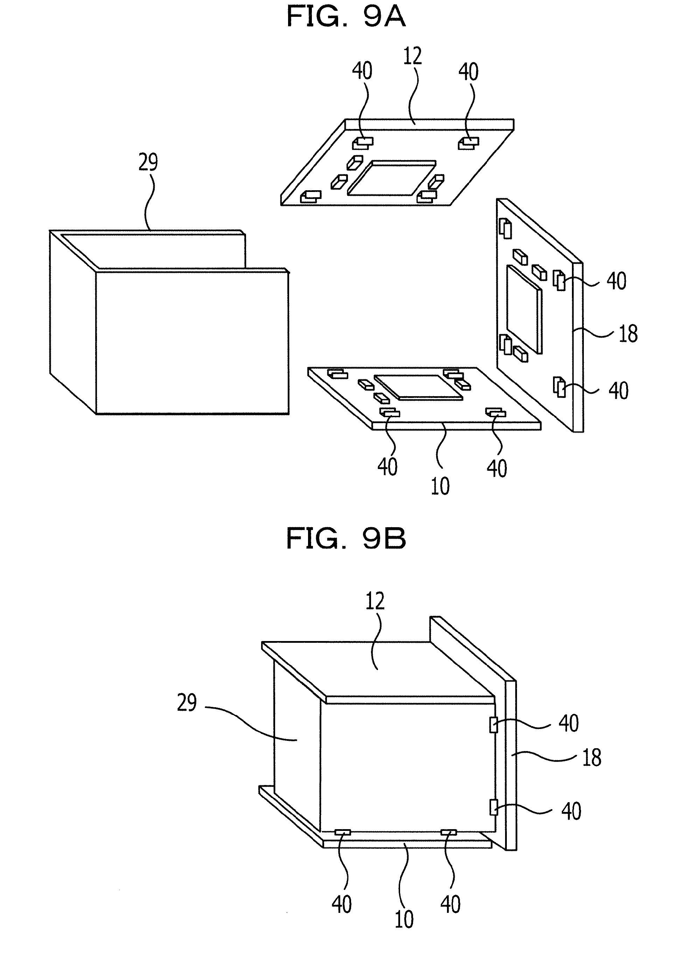

In contrast to the embodiments described above in which two electronic circuit substrates are collectively shielded, the following description with reference to FIGs. 9A and 9B is related to a sixth embodiment in which two or more electronic circuit substrates are collectively shielded.

Referring to FIG. 9A, in a package structure according to the sixth embodiment, a first electronic circuit substrate 10, a second electronic circuit substrate 12, and a third electronic circuit substrate 18 are disposed such that electronic-circuit-mounted surfaces thereof face inward. On-board clips 40 are disposed around the electronic circuit of each electronic circuit substrate. A shielding plate 29 that collectively shields the electronic circuits of the three electronic circuit substrates 10, 12, and 18 has a shape of a folded plate.

FIG. 9B illustrates a state where the three electronic circuit substrates 10, 12, and 18 and the shielding plate 29 are engaged with each other. The electronic circuits of the three electronic circuit substrates 10, 12, and 18 are completely shielded by the first electronic circuit substrate 10, the second electronic circuit substrate 12, the third electronic circuit substrate 18, and the shielding plate 29.

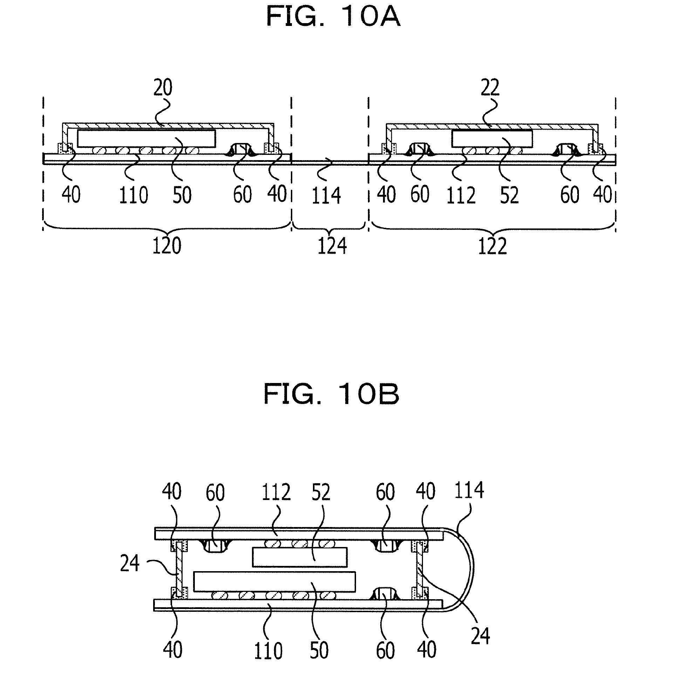

The following description with reference to FIGs. 10A and 10B is related to a package structure according to a seventh embodiment applied to a rigid-flexible substrate obtained by combining flexible and rigid substrates. In FIGs. 10A and 10B, elements that are the same as or equivalent to those in the package structure illustrated in FIGs. 2A and 2B are given the same reference numerals, and descriptions thereof will be omitted.

FIG. 10A illustrates a structure of a rigid-flexible substrate before the seventh embodiment is applied. The rigid-flexible substrate includes a first rigid section 120, a flexible section 124, and a second rigid section 122. In the most typical structure of a rigid-flexible substrate, a rigid layer composed of, for example, glass epoxy is bonded to one surface or each surface of a flexible layer composed of, for example, polyimide, and the flexible layer and the rigid layer are electrically connected to each other through a through-hole.

In the seventh embodiment, the first rigid section 120 has a double-layer structure including a first rigid layer 110 and a flexible layer 114. The flexible section 124 has a single-layer structure including the flexible layer 114. The second rigid section 122 has a double-layer structure including a second rigid layer 112 and the flexible layer 114. If the first rigid section 120 and the second rigid section 122 were to be installed within an electronic apparatus by bending the flexible section 124 such that electronic-circuit-mounted surfaces, that is, the surfaces having shielding plates 20 and 22 mounted thereon, face each other, the shielding plates 20 and 22 would abut against each other, thus making it difficult to reduce the distance between the first rigid section 120 and the second rigid section 122.

Referring to FIG. 10B, in accordance with the seventh embodiment, the electronic circuit of the first rigid section 120 and the electronic circuit of the second rigid section 122 are shielded by a single shielding plate 24. Thus, the distance between the first rigid section 120 and the second rigid section 122 may be significantly reduced, as compared with the package structure before the seventh embodiment is applied.

An electronic apparatus according to an embodiment includes a housing and the package structure, according to any one of the first to seventh embodiments, provided within the housing. For example, in the first embodiment, the electronic apparatus includes a housing, the first and second electronic circuit substrates 10 and 12 provided within the housing and having electronic components mounted thereon, and the shielding plate 24 that is provided between the first and second electronic circuit substrates 10 and 12 and that collectively shields the electronic components of the first and second electronic circuit substrates 10 and 12.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

## Claims

1. A package structure comprising:
a plurality of substrates that have components mounted thereon; and
a shielding member that is provided between the plurality of substrates and that collectively shields the components of the plurality of substrates,
wherein the plurality of substrates are disposed parallel to each other such that surfaces thereof having the components mounted thereon face each other.

2. The package structure according to claim 1, wherein
the shielding member is formed of a frame-shaped plate material.

3. The package structure according to claim 2, further comprising:
a partition plate provided within a frame of the shielding member.

4. A package structure comprising:
a substrate including
a first rigid section that has a first component mounted thereon,
a flexible section, and
a second rigid section that has a second component mounted thereon; and
a shielding member that is provided between the first rigid section and the second rigid section in a state where a surface, having the first component mounted thereon, of the first rigid section and a surface, having the second component mounted thereon, of the second rigid section face each other, and that collectively shields the first component and the second component.

5. An electronic apparatus comprising:
a housing;
a plurality of substrates that have components mounted thereon and that are provided within the housing; and
a shielding member that is provided between the plurality of substrates and that collectively shields the components of the plurality of substrates,
wherein the plurality of substrates are disposed parallel to each other such that surfaces thereof having the components mounted thereon face each other.
